# EUROPÄISCHE PATENTANMELDUNG

(11) **EP 0 681 336 A2**
(43) Veröffentlichungstag der Anmeldung: **08.11.1995**
(21) Anmeldenummer: 95105622.5
(22) Anmeldetag: 13.04.1995
(51) Int. Cl.: H01L 33/00

(54) **Elektronisches Bauteil mit einer Halbleiter-Kompositstruktur**

(30) Priorität: 04.05.1994 DE 4415600
(71) Anmelder: DAIMLER-BENZ AKTIENGESELLSCHAFT, D-70567 Stuttgart (DE)
(72) Erfinder: Zachai, Reinhard, Dr., D-89312 Günzburg (DE); Füsser, Hans-Jürgen, Dr., D-89547 Gerstetten-Dettingen (DE); Gutheit, Tim, D-89073 Ulm (DE)

(57) **Zusammenfassung**

Die Erfindung bezieht sich auf eine Halbleiter-Komposit-Struktur für ein elektronisches Bauteil. Die Halbleiter-Komposit-Struktur weist eine, abgesehen von unvermeidbaren Verunreinigungen, im wesentlichen undotierte Diamantschicht auf, deren eine Seite von einer dotierten, diamantfreien Halbleiter-Schicht bedeckt ist, wobei die Schichten auf einem Wachstum-Substrat angeordnet sind. Der Verlauf der am Übergang zwischen der Halbleiter-Schicht und der Diamantschicht bzgl. des Leitungs- und/oder der Valenzbandes vorliegende Banddiskontinuität ist derart, daß in der Halbleiter-Schicht insbesondere optisch und/oder thermisch angeregte Ladungsträger unter Verringerung ihrer potentiellen Energie in das Valenz- und/oder Leitungsband der undotierten Diamantschicht ableitbar sind.

## Beschreibung

Die Erfindung betrifft ein elektronisches Bauteil mit einer Halbleiter-Komposit-Struktur mit zumindest einer Diamantschicht gemäß dem Oberbegriff des Anspruchs 1, wie es aus der US-PS 51 17 267 als bekannt hervorgeht.

Die US-PS 51 17 267 betrifft ein elektronisches Bauteil, die eine Halbleiter-Komposit-Struktur aufweist. Bei der vorbekannten Halbleiter-Komposit-Struktur ist zur Herstellung eines elektronischen Bauteiles, wie z.B. eines Transistors oder einer Leuchtdiode, auf einer Seite einer p-dotierten Diamantschicht eine n-dotierte kubische Halbleiter-Schicht aus Bornitrid (C-BN) und auf der anderen Flachseite der p-dotierten Diamantschicht eine p-dotierte C-BN-Schicht angeordnet. Diese Bauteile weisen also eine aktive p-dotierte Diamantschicht auf, wobei an deren Bandkante zwischen der n-dotierten C-BN-Schicht und der p-dotierten Diamantschicht eine Banddiskontinuität ausgebildet ist. Allerdings sind die Diamantschichten, die zur Abscheidung von elektronisch verwendbaren Halbleiter-Komposit-Struktur benötigt werden, von geringer kristalliner Qualität, verhältnismäßig aufwendig herzustellen und teuer. Des weiteren weisen derartige Halbleiter-Komposit-Strukturen auch einen hohen Widerstand auf.

Aus der GB 22 28 949 A ist eine Halbleiter-Komposit-Struktur für elektronische Bauteile bekannt, bei der auf einem preisgünstigen Silizium-Substrat mittels CVD eine durch Si-Beigabe n-dotierte Diamantschicht abgeschieden ist. Durch diese, mittels Silizium vorgenommene n-Dotierung der Diamantschichten ist der Widerstand dieser Halbleiter-Komposit-Struktur gegenüber Halbleiter-Komposit-Strukturen, die wie bisher mittels Phosphor und Lithium n-dotiert wurden, geringer. Dennoch weist die Halbleiter-Komposit-Struktur immer noch einen zu hohen Widerstand auf.

Die Aufgabe der Erfindung ist es, die gattungsgemäß zugrundegelegte Halbleiter-Komposit-Struktur dahingehend weiterzuentwickeln, daß deren Widerstand gering ist.

Die Aufgabe wird bei dem zugrundegelegten elektronischen Bauteil mit den kennzeichnenden Merkmalen des Anspruchs 1 gelöst. Aus der zur undotierten Diamantschicht benachbarten, dotierten Halbleiter-Schicht gelangen, bedingt durch die bzgl. des Valenz- und/oder Leitungsbandes am Übergang zwischen der Halbleiter-Schicht und der Diamantschicht vorliegende, geforderte Banddiskontinuität, in der dotierten Halbleiter-Schicht optisch und/oder thermisch generierte Leitungsträger in das Valenz- und/oder Leitungsband der undotierten Diamantschicht. In der die geringere Bandlücke aufweisenden Diamantschicht bilden diese aus der die größere Bandlücke aufweisenden C-BN-Schicht abgeflossenen bzw. aufgenommenen Leitungsträger zumindest quasi-freie Ladungsträger der Diamantschicht, die allenfalls eine geringe Aktivierungsenergie aufweisen, wobei der Widerstand derartiger Halbleiter-Komposit-Strukturen relativ gering ist. Desweiteren müssen Diamantschichten derartiger Halbleiter-Komposit-Struktur nicht notwendigerweise dotiert werden, wodurch auch die damit verbundene Problematik - Reproduzierbarkeit, zusätzliche Verunreinigungen, Störstellen für Versetzungen und dgl. - zumindest geringer sind. So können die ionisierten Ladungsträgerrümpfe nicht oder nur in geringem Umfang als Streuzentren für die Ladungsträger in der aktiven Diamantschicht wirken. Als günstig hat es sich ferner erwiesen, daß bei derartigen Halbleiter-Komposit-Strukturen auf eine einfache und preisgünstige Weise eine n-Dotierung, wie auch eine p-Dotierung möglich ist.

Zweckmäßige Ausgestaltungen der Erfindung sind den Unteransprüchen entnehmbar. Im übrigen wird die Erfindung anhand von in den Figuren dargestellten Ausführungsbeispielen im folgenden erläutert. Dabei zeigt
- Fig. 1: einen Schnitt durch eine einfache Halbleiter-Komposit-Struktur mit vier auf einem Wachstum-Substrat angeordneten unterschiedlichen Schichten,
- Fig. 2: eine Halbleiter-Komposit-Struktur mit anderer Reihenfolge der Schichten nach Figur 1,
- Fig. 3: eine Halbleiter-Komposit-Struktur mit alternierenden Halbleiter- und Diamantschichten und
- Fig. 4: einen schematische Darstellung des Verlaufes der Valenz- und Leitungsbänder in Bereich des Überganges einer Diamantschicht zu einer C-BN-Schicht.

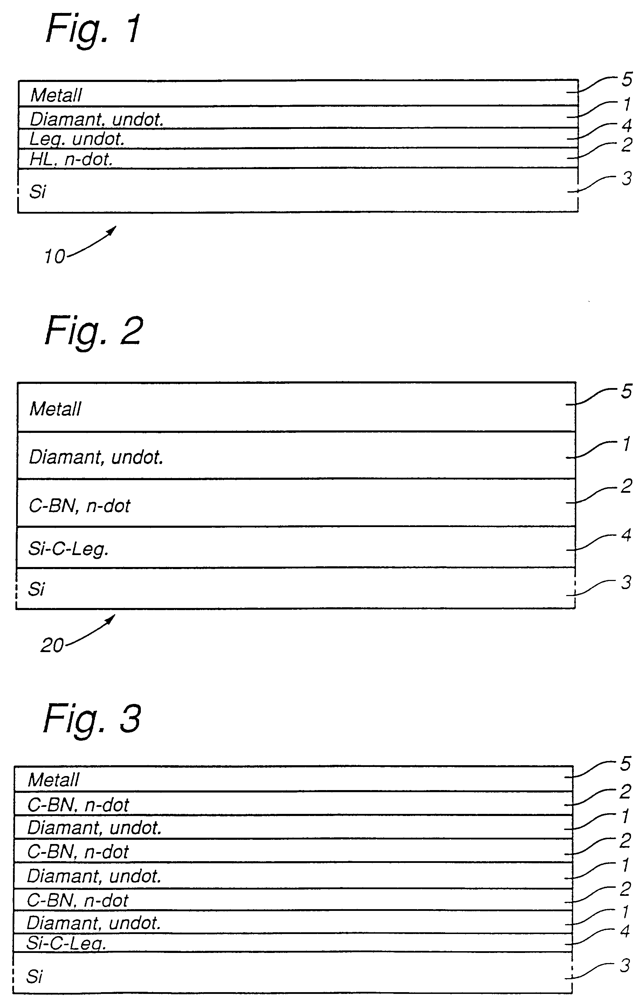

In Figur 1 ist ein Halbleiter-Komposit-Struktur 10 mit vier unterschiedlichen Schichten dargestellt, die auf einem Wachstum-Substrat 3 abgeschieden sind. Die Abscheidung der Schichten über dem Wachtum-Substrat erfolgt zweckmäßigerweise mittels CVD (chemical-vapor-deposition) und/oder MBE (molekular-beam-epitaxy) und/oder verschiedenen Abarten die Epitaxie-Verfahren. Des weiteren ist es zur Herstellung einer derartigen Halbleiter-Komposit-Struktur 10 auch möglich auf das aus Silizium gebildete Wachstum-Substrat 3 eine kristalline Kobalddisilizid (CoSi2) Schicht oder eine Si/C-Legierung aufzutragen, die mit dem Wachstum-Substrat 3 und mit der C-BN-Schicht einen modifizierte Gitteranpassung, auf die später eingegangen wird, aufweisen. Auf dieser Zwischenschicht wird die C-BN-Schicht abgeschieden, wozu mittels eines Lasers aus einem aus hexagonalem Bornitrid (BN) gebildeter Körper Material verdampft, gemeinsam mit einem N2-Gasstrom in Richtung des Wachstum-Substrats 3 transportiert und auf der Zwischenschicht, die auf bspw. 600 °C erhitzt ist, als C-BN-Schicht abgeschieden wird.

Bei diesem Ausführungsbeispiel ist auf dem aus weitgehend einkristallinem, vorzugsweise dotiertem Silizium gebildeten Wachstum-Substrat 3 eine n-dotierte Halbleiter-Schicht 2 bekannter Art abgeschieden. Die Halbleiter-Schicht 2 kann hierbei eine einzige Komponente, zwei Komponenten (binäre Systeme wie bspw. InP), drei und mehr Komponenten (ternäre oder quaternäre Systeme wie InGaAs, InGaAsP oder dgl.) aufweisen. Bei der Auswahl der Halbleiter-Schicht 2 ist es sinnvoll, solche Halbleiter-Systeme auszusuchen, die mit dem zweckmäßigerweise eine (1,0,0)-Orientierung aufweisenden Wachstum-Substrat 3 eine akzeptable Gitteranpassung aufweist.

Eine gute direkte Gitteranpassung bedeutet, daß die Gitterkonstante der Halbleiter-Schicht 2 nur geringfügig von der Gitterkonstanten des Wachstum-Substrats 3 abweicht. Ferner kann zwischen der Halbleiter-Schicht 2 und dem Wachstum-Substrat 3 auch eine modifizierte Gitteranpassung vorliegen. Allgemein bedeutet eine modifizierte Gitteranpassung, daß die Differenz eines ganzzahligen Vielfachen der Gitterkonstanten des ersten Materials und eines ganzzahligen Vielfachen der Gitterkonstanten des zweiten Materials, bezogen auf das ganzzahlige Vielfache des einen Materials, kleiner 20%, insbesondere kleiner 10%, und günstigerweise kleiner als 1% ist.

Das ganzzahlige Vielfache der Gitterkonstanten kann der jeweiligen Gitterkonstanten entsprechen, wodurch es sich bei diesem Grenzfall um die einfache, direkte Gitteranpassung handelt. Des weiteren können die ganzzahligen Vielfachen für die jeweiligen Gitterkonstante unterschiedlich sein. Günstig ist es hierbei, wenn die Vielfachen der Gitterkonstanten kleiner als 10, insbesondere kleiner als 5 sind. Ein sinnvolles Verhältnis ist hierbei ein 2:3-Verhältnis.

Auf der Halbleiter-Schicht 2 ist zum Abbau der Gitterfehlanpassung zwischen der Halbleiter-Schicht 2 und der nachfolgend abzuscheidenden Diamantschicht 1 eine Zwischenschicht 4 abgeschieden. Die Zwischenschicht 4 kann eine Legierung sein, die ein kristallographisch regelmäßiges, eine Diamant- oder eine Calziumfluorid- oder eine Zinkblendestruktur aufweisendes Legierungsgitter aufweist, wobei sich die Zusammensetzung der Legierung mit zunehmendem Abstand von der Halbleiter-Schicht 2 verändert. Mit Veränderung der Zusammensetzung der Legierung ist eine Änderung der Gitterkonstanten des Legierungsgitters verbunden, weshalb die Gitterkonstante der Legierung in weiten Grenzen variiert werden kann. Durch diese große Variation der Gitterkonstanten des Legierungsgitters ist mittels der derartigen Zwischenschicht 4 in einfacher Weise eine direkte oder eine modifizierte Gitteranpassung zwischen der Halbleiter-Schicht 2 und der Diamantschicht 1 realisiert. Alternativ zu der Legierung ist eine Zwischenschicht 4 aus Kobalddisilizid (CoSi2), die zu einer aus C-BN gebildeten Halbleiter-Schicht 2 hin eine Gitterfehlanpassung kleiner 1 % aufweist.

Auf der Diamantschicht 1, die bis auf unvermeidbare Verunreinigungen im wesentlichen undotiert abgeschieden ist, ist eine Metallschicht 5 aufgebracht, die sinnvollerweise als Gate wirkt und die bspw. durch Aufdampfen aufgebracht sein kann.

Das Material der Halbleiter-Schicht 2 ist nun bezüglich der Diamantschicht 1 derart abgestimmt, daß, bedingt durch eine zwischen diesen Schichten 1, 2 vorliegende Banddiskontinuität der Leitungsbänder dieser Schichten 1, 2, optisch und/oder thermisch aktivierte Ladungsträger der n-dotierten Halbleiter-Schicht 2 unter Verringerung ihrer potentiellen Energie in das Leitungsband der undotierten Diamantschicht 1 abfließen, wobei die Ladungsträger der Halbleiter-Schicht 2 über die Zwischenschicht 4 Ladungsträger aus der Halbleiter-Schicht 2 in die Diamantschicht 1 abgeleitet werden. Dadurch ist die Diamantschicht 1 dieser Halbleiter-Komposit-Struktur 10, ohne direkte n-Dotierung, vom n-Typ.

Auf die gleiche Weise ist es auch ohne direkte Dotierung möglich, Halbleiter-Komposit-Strukturen mit Diamantschichten vom p-Typ herzustellen, wobei hier das Material der Halbleiter-Schicht derart abgestimmt sein muß, daß in diesem Fall, bedingt durch die zwischen diesen Schichten vorliegende Banddiskontinuität der Valenzbänder dieser Schichten, optisch und/oder thermisch aktivierte Ladungsträger der nunmehr p-dotierten Halbleiter-Schicht unter Verringerung ihrer potentiellen Energie durch die Legierung hindurch in das Valenzband der undotierten Diamantschicht abfließen und eine Diamantschicht vom p-Typ erzeugen.

Mit Halbleiter-Komposit-Struktur, die einen prinzipiellen Aufbau wie das Halbleiter-Komposit-Struktur gemäß dem Ausführungsbeispiel nach Figur 1 aufweisen, lassen sich u.a. elektronische Bauteile wie Leuchtdioden mit im Bereich des Blauen emittierenden Licht oder Feld-Effekt-Transisitoren realisieren, wobei die hohe Wärmeleitfähigkeit der Diamantschicht 1 von hohem Vorteil ist.

In Figur 2 ist ein Halbleiter-Komposit-Struktur 20 dargestellt, das ebenfalls mehrere auf einem aus dotiertem oder undotiertem, kristallinem Silizium bestehenden Wachstum-Substrat 3 nacheinander abgeschiedene Schichten aufweist. Die erste, auf dem Wachstum-Substrat 3 abgeschiedene Zwischenschicht 4 ist aus einer Kohlenstoff/Silizium Legierung gebildet, die ein diamantähliches bzw. zinkblendeähnliches Legierungsgitter aufweist, in dem die einzelnen Legierungsatome statistisch verteilt angeordnet sind, wobei der Anteil der Kohlenstoffatome mit zunehmender Dickenerstreckung der Zwischenschicht 4 zu- und der Anteil der Siliziumatome mit zunehmender Dickenerstreckung der Zwischenschicht 4 abnimmt. Dadurch wird erreicht, daß sich die Gitterkonstante der Zwischenschicht 4 von einem Wert, der in etwa der Gitterkonstanten des aus Silizium gebildeten Wachstum-Substrats 3 entspricht, zu einem Wert hin abnimmt, der in etwa der Gitterkonstanten von kubischem Bornitrid (C-BN) entspricht. Dies ist daher sinnvoll, da auf die Zwischenschicht 4 anschließend eine n-dotierte C-BN-Schicht als Halbleiter-Schicht 2 abgeschieden wird, deren Gitterkonstante gegenüber der des Wachstum-Substrat 3 aus Si um mehr als 50% differiert, wodurch bei direkter Abscheidung die Halbleiter-Schicht 2 aus C-BN allenfalls eine unbefriedigende Qualität aufweisen würde. Auf der Halbleiter-Schicht 2 aus C-BN ist eine undotierte Diamantschicht 1 angeordnet, auf welcher wiederum eine ein Gate ausbildende Metallschicht 5 abgeschieden ist. Da zwischen dieser Halbleiter-Schicht 2 aus C-BN und der Diamantschicht 1 eine Banddiskontinuität ausgebildet ist, aufgrund deren Ladungsträger, die in der n-dotierten Halbleiter-Schicht 2 thermisch und/oder optisch angeregt sind, unter Verringerung ihrer potentiellen Energie in das Leitungsband der undotierten Diamantschicht 1 gelangen können, liegt auch in diesem Fall einer Halbleiter-Komposit-Struktur 20 eine Diamantschicht 1 vom n-Typ vor. Hierbei ist es von Vorteil, daß die die Ladungsträger spendende Halbleiter-schicht 2 direkt an der diese Ladungsträger sammelnden Diamantschicht 1 verbunden angeordnet ist.

Mit Halbleiter-Komposit-Struktur, die einen prinzipiellen Aufbau wie das Halbleiter-Komposit-Struktur gemäß dem Ausführungsbeispiel nach Figur 2 aufweisen, lassen sich ebenso insbesondere elektronische Bauteile wie Feldeffekt-Transistoren realisieren.

In Figur 3 ist eine Halbleiter-Komposit-Struktur dargestellt, die einen alternierenden Aufbau von sich mit undotierten Diamantschichten 1 abwechselnden Halbleiter-Schichten 2 aufweist. Die sich abwechselnden Schichten 1, 2 aus n-dotiertem Bornitrid und undotiertem Diamanten sind zwischen einer auf der letzten n-dotierten Halbleiter-Schicht 2 aus C-BN angeordneten Metallschicht 5 und dem Wachstum-Substrat 3 angeordnet, wobei auf das Wachstum-Substrat 3 als Zwischenschicht 4 eine Si-C-Legierung aufgebracht ist. Der Zwischenschicht 4 folgt wiederum eine undotierte Diamantschicht 1. Bei dieser Ausgestaltungsform der Halbleiter-Komposit-Struktur 30 ist u.a. von Vorteil, daß die Diamantschicht 1, wenn die beiden benachbarten Halbleiter-Schichten 2 die gleiche Dotierung aufweisen, von beiden Seiten mit Ladungsträgern beaufschlagt und die Ladungsträgerdichte in der Diamantschicht 1 erhöht wird.

Mit Halbleiter-Komposit-Strukturen, die einen prinzipiellen Aufbau wie das Halbleiter-Komposit-Struktur gemäß dem Ausführungsbeispiel nach Figur 3 aufweisen, lassen sich bspw. elektronische Bauteile wie Feld-Effekt-Transistoren oder Tunneldioden realisieren. Insbesondere ist eine derartige Halbleiter-Komposit-Struktur 30 für Leuchtdioden (LED) sinnvoll, da auf diese Art positive wie negative Ladungsträger frei in großer Dichte in der eigentlich undotierten Diamantschicht 1 vorliegen und rekombinieren können. Um diesen Vorgang z Verbessern, kann es zweckmäßig sein, innerhalb der Komposit-Struktur 30 mechanische Spannungen hervorzurufen oder einzubauen, die den Wert für dieses, diesen Übergang betreffende Übergangsmatrixelement erhöhen.

Eine weitere Möglichkeit ist es, zwischen der dotierten C-BN-Schicht 2 und der undotierten, intrinsischen Diamantschicht 1 eine dünne undotierte C-BN-Schicht (nicht eingezeichnet) anzuordnen. Dadurch ist die Dotierung der gesamten C-BN-Schicht über ihre Schichtdicke inhomogen, weshalb die Streuwirkung der Majoritätsladungsträger reduziert ist.

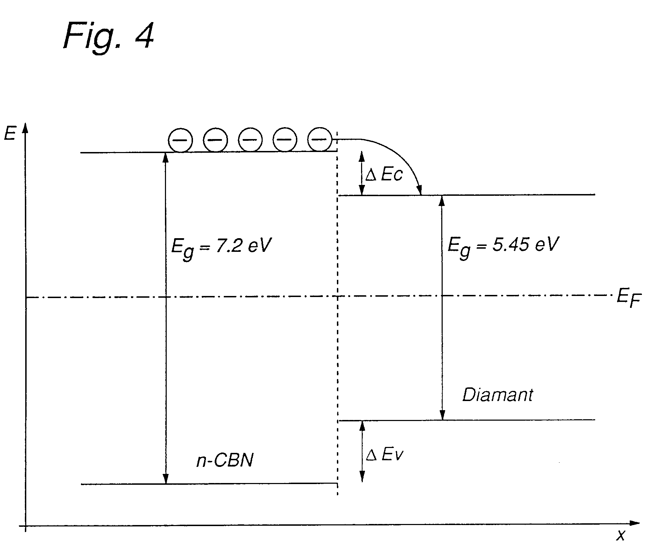

In Figur 4 ist eine schematische Darstellung eines Bandverlaufes zwischen einer C-BN-Schicht und einer Diamantschicht an ihrem Materialübergang dargestellt. Aus der einen Seite des Banddiagrammes ist die Bandlücke des C-BN mit einem Wert von etwa 7,2 eV aufgetragen, der sich die Bandlücke des Diamanten mit etwa %,45 eV anschließt, wobei als gemeinsames Niveau das Ferminiveau (gestrichelte Linie Ef) eingezeichnet ist. Der Bandlükkenunterschied zwischen den beiden Bandlücken verteilt sich ungefähr zu gleichen Teilen auf das Valenzband (Ev) und das Leitungsband (Ec). Der Unterschied ΔEc bzgl. des Leitungsbandes Ec bildet die Schwelle dafür, daß die negativen Ladungsträger wieder thermisch angeregt ins C-BN gelangen können, wobei bei Temperaturen unterhalb 600 °C dieser Unterschied ΔEc bzgl. des Leitungsbandes Ec sehr viel größer ist als die thermische Energie der Ladungsträger.

## Patentansprüche

1. Halbleiter-Komposit-Struktur für ein elektronisches Bauteil mit wenigstens einer Diamantschicht, deren eine Seite von einer dotierten, diamantfreien Halbleiter-Schicht bedeckt ist, sowie einem Wachstum-Substrat auf dem die Schichten angeordnet sind, wobei Leitungs- und/oder der Valenzbandkantenverlauf der Halbleiter-Komposit-Struktur zwischen der Diamantschicht und der Halbleiter-Schicht eine Banddiskontinuität aufweist,
**dadurch gekennzeichnet,**
daß die Diamantschicht (1) im wesentlichen undotiert ist und daß durch den Verlauf der Banddiskontinuität in der Halbleiter-Schicht (2) insbesondere optisch und/oder thermisch angeregte Ladungsträger unter Verringerung ihrer potentiellen Energie in das Valenz- und/oder Leitungsband der undotierten Diamantschicht (1) ableitbar sind.

2. Elektronisches Bauteil nach Anspruch 1,
**dadurch gekennzeichnet,**
daß die Halbleiter-Komposit-Struktur (30) eine alternierende Schichtfolge aus dotierter Halbleiter-Schicht (2) und undotierter Diamantschicht (1) aufweist.

3. Elektronisches Bauteil nach Anspruch 1,
**dadurch gekennzeichnet,**
daß das Wachstum-Substrat (3) der Halbleiter-Komposit-Struktur (10, 20, 30) ein Silizium oder ein GaAs-Substrat, vorzugsweise bzgl. der Miller schen Indizes in (1,0,0)-Orientierung ist.

4. Elektronisches Bauteil nach Anspruch 1,
**dadurch gekennzeichnet,**
daß das Wachstum-Substrat (3) der Halbleiter-Komposit-Struktur (10, 20, 30) undotiert ist.

5. Elektronisches Bauteil nach Anspruch 1,
**dadurch gekennzeichnet,**
daß die Halbleiter-Schicht (2) aus Bornitrid (BN), insbesondere aus kubischem Bornitrid (C-BN) gebildet ist.

6. Elektronisches Bauteil nach Anspruch 1,
**dadurch gekennzeichnet,**
daß die Halbleiter-Schicht (2) n-dotiert ist.

7. Elektronisches Bauteil nach Anspruch 1,
**dadurch gekennzeichnet,**
daß in der Halbleiter-Komposit-Struktur (10, 20) dem Wachstum-Substrat (3) zunächstliegend die Halbleiter-Schicht (2) und darauf die Diamantschicht (1) angeordnet ist.

8. Elektronisches Bauteil nach Anspruch,
**dadurch gekennzeichnet,**
daß zwischen dem Wachstum-Substrat (3) und der Halbleiter-Schicht (2) zur Verbesserung einer modifizierten Gitterfehlanpassung zwischen einem ganzzahligen Vielfachen der Gitterkonstanten des Wachstum-Substrats (3) und einem ganzzahligen Vielfachen der Gitterkonstanten der Halbleiter-Schicht (2) eine Zwischenschicht (4), insbesondere eine Legierung mit innerhalb des Legierungsgitters statistisch angeordneten Legierungsatomen angeordnet ist, wobei die Art des Kristallgitters der Zwischenschicht (4) zumindest ähnlich derjenigen der Halbleiter-Schicht (2) ist.

9. Elektronisches Bauteil nach Anspruch 1,
**dadurch gekennzeichnet,**
daß die Halbleiter-Komposit-Struktur (10, 20, 30) eine Metallschicht (5) aufweist, die insbesondere auf der Diamantschicht (1) angeordnet ist.

10. Elektronisches Bauteil nach Anspruch 1,
**dadurch gekennzeichnet,**
daß zwischen der Halbleiter-Schicht (2) und der Diamantschicht (1) zur Verringerung einer modifizierten Gitterfehlanpassung zwischen einem ganzzahligen Vielfachen der Gitterkonstanten der Diamantschicht (1) und einem ganzzahligen Vielfachen der Gitterkonstanten der Halbleiter-Schicht (2) eine Zwischenschicht (4), insbesondere eine Legierung mit einem Legierungsgitter in Diamantstruktur oder Zinkblendestruktur oder Calziumfluoridstruktur, angeordnet ist, wobei über die Zwischenschicht (4) Ladungsträger aus der dotierten Halbleiter-Schicht (2) in die undotierte Diamantschicht (1) ableitbar sind.

11. Elektronisches Bauteil nach Anspruch 10,
**dadurch gekennzeichnet,**
daß die Zwischenschicht (4) aus einer ein Legierungsgitter in Diamantstruktur oder Zinkblendestruktur aufweisenden Silizium-Kohlenstoff-Legierung gebildet ist, deren Kohlenstoffanteil innerhalb der Zwischenschicht (4) mit zunehmendem Abstand von der Halbleiter-Schicht (2) ansteigt und deren Siliziumanteil entsprechend abnimmt.
